# EUROPEAN PATENT SPECIFICATION

(11) **EP 2 862 363 B1**
(45) Date of publication and mention of the grant of the patent: **08.03.2017**
(21) Application number: 12735625.1
(22) Date of filing: 15.06.2012
(51) Int. Cl.: H04Q 1/08, H05K 7/12

(54) **ASSEMBLY AND METHOD FOR MANAGING COMPONENTS OF A TELECOMMUNICATION SYSTEM**
ANORDNUNG UND VERFAHREN ZUR VERWALTUNG VON KOMPONENTEN EINES TELEKOMMUNIKATIONSSYSTEMS
SYSTÈME ET PROCÉDÉ POUR LA GESTION DE COMPOSANTS D'UN SYSTÈME DE TÉLÉCOMMUNICATIONS

(43) Date of publication of application: 22.04.2015
(73) Proprietor: Prysmian S.p.A., 20126 Milano (IT)
(72) Inventor: PIKE, Stephen, I-20126 Milano (IT)
(74) Representative: Castiglia, Paolo
(86) International application number: PCT/IB2012/001215
(87) International publication number: WO 2013/186583

(56) References cited:
- US-A1- 2009 074 534
- US-A1- 2010 052 484
- US-A1- 2011 304 247

## Description

The present invention relates to an assembly and a method for managing components of a telecommunication system.

In particular, the assembly and the method of the invention allow securing components of a telecommunication system on supporting frames according to a desired layout.

Throughout the present description and the attached claims, the term "component" is used to indicate both devices of telecommunication systems and cables and/or wires associated to such devices.

A telecommunication system typically comprises many electronic or optoelectronic devices (such as for example transmitter, receivers, routers, amplifiers, etc.) having a plurality of electrical or optical cables (or wires) attached thereto.

The abovementioned devices are usually mounted on supporting frames (such as for examples plates, panels or racks) by means of suitable supporting members. The supporting frames can in turn be mounted within protective cabinets for indoor or outdoor use.

Accessory members can be mounted on the supporting frames in order to properly support the cables (or wires) associated with the aforementioned devices.

The number of the devices and/or cables to be mounted on a single supporting frame can be very high. Therefore, an organized layout of the aforementioned supporting members and/or accessory members on the supporting frame is often required and desired in order to minimize the space occupied by the devices and/or cables and to reduce the likelihood of cables tangling and damaging. The organized layout should also ensure no excessive bending of the cables in order to provide for easiness of mounting and dismounting of the devices and/or cables as well as not to cause attenuation and loss of signal strengths.

US 2011/0304247 discloses a server cabinet for housing a plurality of servers. The server cabinet includes two brackets and two guiding fixtures respectively engaged with the two brackets. Each bracket defines a latching hole. Each guiding fixture includes a supporting member and a latching member. The latching member includes a plate and a pivot extending from the plate. A plurality of protrusions extends outwards from an end of the pivot. The latching member is rotated to engage protrusions with the corresponding bracket at a periphery of the latching hole after the end of the pivot extends through the supporting member and the latching hole of the bracket.

US 2011/0211329 discloses an equipment cabinet including an equipment rack for mounting equipments of a telecommunication systems. The equipment cabinet further includes organizational elements for organizing cables within the cabinet. The organizational elements may include one or more of: a plug including an universal clip, a bracket (either vertical or horizontal), a termination panel, a trunk cable manager, an accessory bracket, a fiber module bracket and a rotating fiber retaining spool. The accessory bracket may be mounted anywhere along the height of a vertical member of the equipment rack and is generally a C-shaped rail with a back plate, a first leg and a second leg. The back plate includes holes to receive fasteners to mount the accessory bracket to the vertical member and the legs extend from the back plate, away from the vertical member. Both the legs include mounting holes for mounting equipment, for example a termination panel, a series of fiber module brackets or the end of a horizontal bracket to the accessory bracket and, thus, to the equipment rack. The second leg further includes a series of vertical slot-type openings alternating with the mounting holes. The slot-type openings may be threaded with tie-down devices, e.g. Velcro® ties, for use in managing and organizing optical fibers in the side panel space.

US 7,083,051 discloses a cable management assembly for use in telecommunication systems. The cable management assembly includes a panel having an interface portion and a plurality of cable management devices. The interface portion has a plurality of shaped apertures to secure the cable management devices to the panel at selected vertical and horizontal locations. The cable management devices are configured to insert within any of the shaped aperture to provide a variety of cable management arrangements or configurations from which an user may choose to position the cable management devices. Each cable management device is secured to the panel by inserting protrusions or pin connections into the shaped apertures so that it cannot be pulled or pushed out of position. The device can be slid or lifted for removal. The cable management device can include a tensioning component, such as spring washers or flexible tensioning tabs, which places the pin connections in tension to assist in maintaining a secure engagement between the device and the panel.

US 7,677,400 discloses a cable management assembly for use in telecommunication systems. The cable management assembly includes a panel and cable managing devices. Each cable managing device has a black plate having securing structure configured to secure the device to the panel. Holes are provided in the back plate of the device to receive fasteners for attaching the device to the back plate. The securing structure includes hooks, a flexible tab and a locating element. The panel has a plurality of discrete openings including a first type of shaped apertures which correspond to the shape of the hooks and a second type of shaped apertures which correspond to the shape of the locating element. The locating element is shaped such that the cable management device can be mounted and attached to the panel in only a particular orientation. The cable managing device secures to the panel by placing the hooks within the first type of shaped apertures. The flexible tab is then inserted and snapfitted into a corresponding third attaching aperture. Then the locating element is engaged in the second type of shaped aperture. To remove the cable management device from the panel the flexible tab is first removed from the third attaching aperture by inserting a tool, such as a screwdriver, into a notch and applying an upward force.

The Applicant observed that in the above-described assemblies different types of supporting members are needed to secure different types of components of a telecommunication systems on the equipment racks or panels. In addition thereto, tensioning elements or flexible tabs are used to achieve a secure engagement between supporting devices and equipment racks or panels. Furthermore, tools and separate conventional fastening elements are often required to secure/remove each supporting device to/from the equipment racks or panels, thus making the mounting/dismounting operation of the supporting devices complex and time-consuming.

The Applicant faced the problem of obtaining a steady engagement of components of different types and shapes with a supporting frame, with no need to use flexible tabs or tensioning elements and wherein mounting and dismounting of the components onto the supporting frame do not require the use of tools or fastening elements.

The Applicant found that the desired steady engagement of the components with the supporting frame can be achieved by associating said components to appropriate supporting members configured to be inserted into shaped openings of the supporting frame, wherein such supporting members are specifically designed so as to allow mounting/dismounting thereof onto/from the supporting frame without the use of tools and such that, when properly mounted onto the supporting frame, any degrees of freedom with respect to the supporting frame is lost.

More particularly, the Applicant realized that each supporting member, before engaging with the supporting frame, has three degrees of freedom in translation with respect to the supporting frame - two degrees of freedom in the lying plane of the supporting frame and one degree of freedom along a direction perpendicular to the aforementioned laying plane - and that a steady engagement of the supporting member with the supporting frame can be achieved by positioning the supporting member into the shaped opening of the supporting frame such that all the aforementioned degrees of freedom are eliminated.

Accordingly, in a first aspect thereof, the present invention relates to an assembly for managing components of a telecommunication system according to claim 1.

In a second aspect thereof, the present invention relates to a method for managing components of a telecommunication system according to claim 12.

The terms "above" and "below" are used below with reference to the supporting frame when oriented horizontally, that is when the inserting direction of the supporting member into the shaped opening of the supporting frame is substantially vertical. More specifically, "above" will be used to refer to a point of observation in which the top surface of the supporting frame is seen whereas "below" will be used to refer to a point of observation in which the bottom surface of the supporting frame is seen.

In at least one of the aforementioned aspects the invention can comprise at least one of the following preferred features, taken separately or in combination.

Preferably, said supporting member is movable within said shaped opening between an inserting position defined along an inserting direction and a locking position, and wherein said integral portion comprises a hook element which, when the supporting member is at the locking position, is inserted into the shaped opening and prevents any movement of the supporting member in the opposite way to said inserting direction.

Preferably, when said supporting member is at said locking position, said hook element further prevents any movement of the supporting member along a first direction perpendicular to said inserting direction.

Preferably, when said locking element is at said second operative position the supporting member is at said locking position and the locking element is inserted into said shaped opening, thus preventing any movement of the supporting member along a second direction perpendicular to said inserting direction and to said first direction.

In preferred embodiments of the invention, said supporting member is substantially U-shaped and comprises a bottom wall and two opposite side walls, said hook element extending from said bottom wall on the opposite side with respect to said side walls and said locking element being associated with one of said side walls and movable along said direction parallel to said inserting direction.

Preferably, a tie element adapted to be associated with said supporting member to secure said component onto said supporting frame is provided.

Preferably, said supporting member comprises at least one slot for associating said tie element with the supporting member.

More preferably, said at least one slot is formed on one of said side walls.

In preferred embodiments of the invention, at least two slots are formed on each of said side walls.

Preferably, said tie element is a double sided Velcro^{®} strap.

In preferred embodiments of the invention, said shaped opening is cross-shaped or T-shaped or star-shaped.

Preferably, before moving said locking element from said first operative position to said second operative position, said supporting member is moved within said shaped opening from the inserting position to a locking position in which any movement of the supporting member in the opposite way to the inserting direction is prevented.

In preferred embodiments thereof, the invention comprises:
- arranging said component onto said supporting frame in a position adjacent to said supporting member;
- associating a tie element with said supporting member to secure said component onto said supporting frame.

Preferably, said component comprises a device provided with a cable and said supporting member is substantially U-shaped and comprises a bottom wall and two opposite side walls, each provided with at least one slot for the passage of said tie element, wherein associating a tie element with said supporting member comprises passing said cable between said side walls and between said bottom wall and said tie element.

In preferred embodiments of the invention, said supporting member, before the insertion into said shaped opening, has three degrees of freedom in translation with respect to said supporting frame. Preferably, when said integral portion of said supporting member is inserted into said shaped opening, said supporting member looses two of said degrees of freedom with respect to said supporting frame. More preferably, when said locking element is inserted into said shaped opening, said supporting member looses the last of said degrees of freedom with respect to said supporting frame.

Further features and advantages of the present invention will appear more clearly from the following detailed description of some preferred embodiments thereof, such description being provided merely by way of non-limiting example and being made with reference to the annexed drawings. In such drawings:
- figure 1 is a schematic perspective view from the above of an assembly according to a preferred embodiment of the present invention in a first operative configuration thereof;
- figure 2a is a schematic perspective view from the above of the assembly of figure 1 in a second operative configuration thereof;
- figure 2b is a schematic partially sectioned perspective view from below of the assembly of figure 1 in the second operative configuration thereof;

- figure 3a is a schematic perspective view from the above of the assembly of figure 1 in a third operative configuration thereof;
- figure 3b is a schematic partially sectioned perspective view from below of the assembly of figure 1 in the third operative configuration thereof;
- figure 4a is a schematic partially sectioned perspective view from the above of the assembly of figure 1 in a fourth operative configuration thereof;
- figure 4b is a schematic partially sectioned perspective view from below of the assembly of figure 1 in the fourth operative configuration thereof;
- figure 5 is a schematic perspective view from the above of the assembly of figure 1 in a preferred operative configuration thereof;
- figure 6 is a schematic side view of the assembly of figure 1 in a further preferred operative configuration thereof.

In the attached drawings, a preferred embodiment of an assembly for managing components of a telecommunication system according to the present invention is indicated with numeral reference 10.

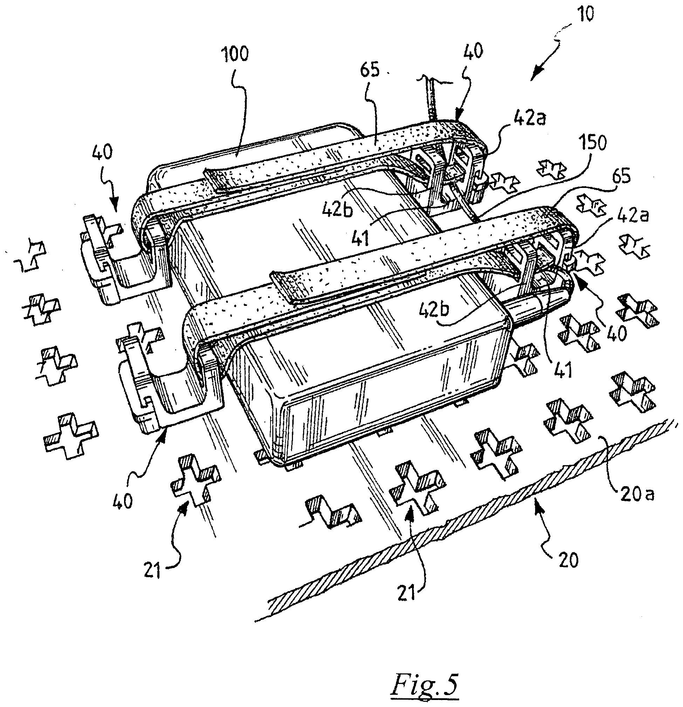

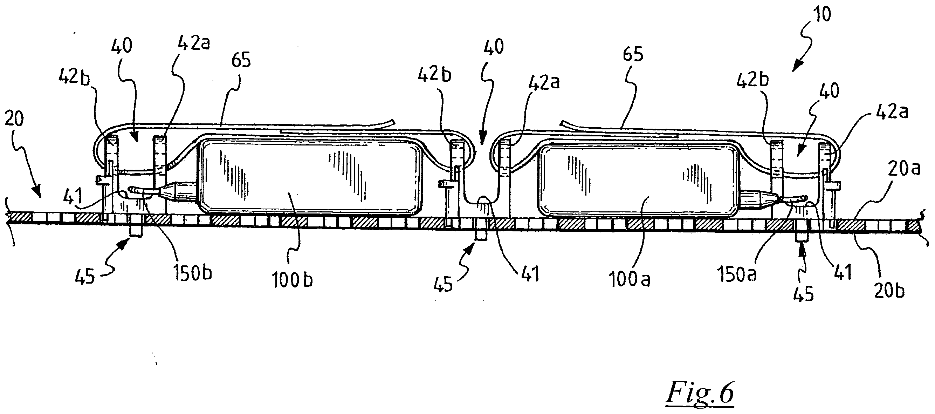

Assembly 10 is used for properly supporting components of a telecommunication system. Such components are shown for example as the devices indicated in figures 5 and 6 with numeral reference 100, 100a, 100b and/or cables associated with the above devices and indicated in figures 5 and 6 with numeral references 150, 150a, 150b.

Devices 100, 100a and 100b of figures 5 and 6 are for example electronic or optoelectronic devices (such as for example transmitter, receivers, routers, amplifiers, etc.).

Assembly 10 can in turn be mounted within protective cabinets (not shown in the attached drawings) for indoor or outdoor use.

As better explained below, assembly 10 of the present invention advantageously allows both device supporting and cable management according to a desired layout.

While the following description will be made with reference to the horizontal configuration shown in the attached drawings, that is a configuration suitable for horizontally supporting components 100, 100a, 100b, 150, 150a, 150b (for example for floor installations), the skilled person will understand that what described similarly applies to a vertical configuration, that is a configuration suitable for vertically supporting components 100, 100a, 100b, 150, 150a, 150b (for example for wall installations).

The assembly 10 comprises a supporting frame 20 having a top surface 20a and a bottom surface 20b.

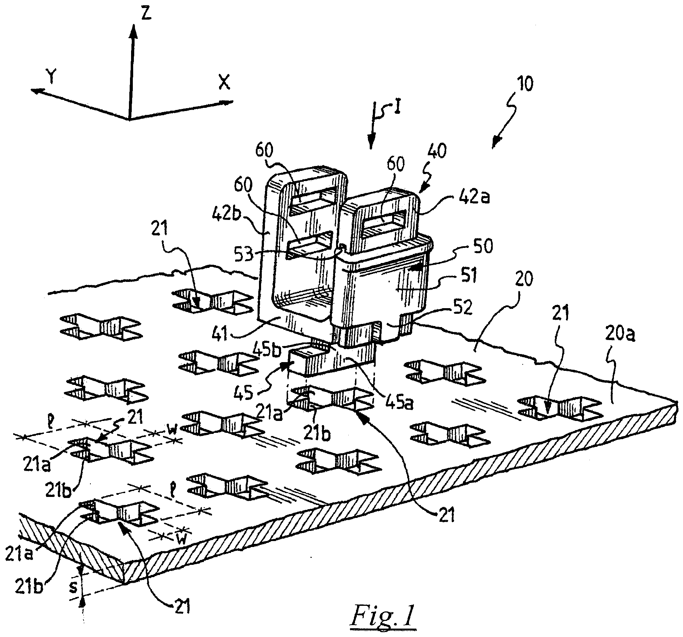

Referring to a Cartesian reference system XYZ oriented as shown in figure 1, the supporting frame 20 lies in a horizontal plane X-Y.

The supporting frame 20 comprises a plurality of shaped openings 21. For the sake of clarity, the numeral reference 21 is associated with only some of the shaped openings shown in the attached drawings.

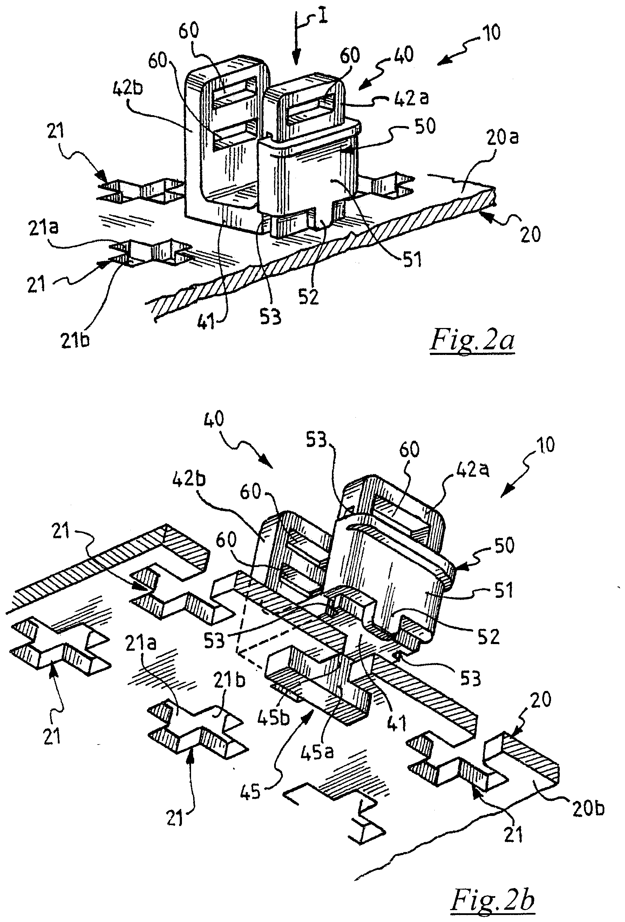

Openings 21 are through-openings, that is they are open both at the top surface 20a (see figures 1, 2a, 3a, 4a) and at the bottom surface 20b (see figures 2b, 3b, 4b) of the supporting frame 20.

All the openings 21 are identically shaped. Specifically, in the example shown in the attached drawings, all openings 21 are cross-shaped, that is each openings 21 comprises two rectilinear through-apertures 21a, 21b intersecting to each other. However, embodiments of the invention wherein openings 21 are T-shaped, star-shaped or differently shaped are also provided.

Preferably, all the apertures 21a, 21b have the same length 1 and the same width W (figure 1).

As shown in figure 1, the assembly 10 further comprises, in the simplest embodiment thereof, a supporting member 40 intended to be used for securing components 100, 100a, 100b, 150, 150a, 150b onto the supporting frame 20.

The supporting member 40 is preferably made of plastic material (for example glass filled nylon, GFN).

In the specific example shown in the attached drawings, supporting member 40 is substantially U-shaped and comprises a bottom wall 41 and two opposite side walls 42a, 42b, respectively. The side walls 42a, 42b in operation extend from the bottom wall 41 on the opposite side with respect to the supporting frame 20.

An integral portion 45 of the supporting member 40 projects from the bottom wall 41 on the opposite side with respect to the side walls 42a, 42b.

In the exemplary embodiment shown in the attached drawings, the aforementioned integral portion comprises a hook element 45.

Hook element 45 is adapted to be inserted into the shaped opening 21 of the supporting frame 20 by moving the supporting member 40 towards the supporting frame 20 along an insertion direction which is indicated with arrow I in figure 1. The inserting direction I is parallel to axis Z of the Cartesian reference system XYZ in figure 1, i.e. the inserting direction is orthogonal to the supporting frame 20.

Hook element 45 is substantially T-shaped, that is it comprises a horizontal portion 45a and a vertical portion 45b connecting a central area of the horizontal portion 45a to the bottom wall 41 of the supporting member 40 (as shown in figures 1, 2b, 3b and 4b).

The vertical portion 45b extends away from the bottom wall 41 for a length substantially equal to the thickness S of the supporting frame 20. The horizontal portion 45a extends, along a direction parallel to axis X in figure 1 (i.e. a direction orthogonal to the supporting frame 20), for a length greater than the width W and at most equal to the length 1 of the aperture 21a, 21b of openings 21, preferably for a length substantially equal to the length 1 of the aperture 21a, 21b. The horizontal portion 45a has a width, along a direction parallel to axis Y in figure 1, at most equal to the width W of the apertures 21a, 21b, preferably substantially equal to the width W of the apertures 21a, 21b.

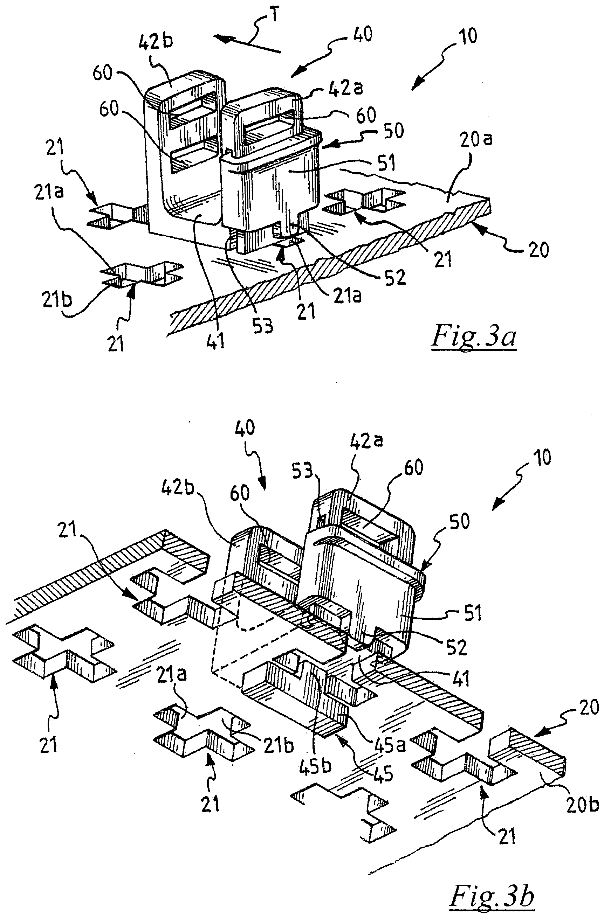

In view of the above, the hook element 45 can be inserted into the opening 21 by aligning the horizontal portion 45a with one of the apertures 21a, 21b (in particular, aperture 21b in figure 1) and subsequently moving the supporting member 40 along the insertion direction I towards the supporting frame 20 up to reach an inserting position in which the bottom wall 41 of the supporting member 40 abuts against the top surface 20a of the supporting frame 20 (figures 2a and 2b). When the supporting member 40 is in the inserting position the horizontal portion 45a thereof projects below the bottom surface 20b of the supporting frame 20 just of a distance suitable for allowing translation of the supporting member 40 within the other apertures 21b, 21a (in particular, aperture 21a in figure 1) of the same opening 21 from the inserting position of figure 2a to a locking position shown in figures 3a, 3b (said translation is thus carried out along a direction parallel to axis Y in figure 1, i.e. parallel to the supporting frame 20, and is indicated with arrow T in figure 3a). When the supporting member 40 is in the locking position, the bottom wall 41 thereof abuts against the bottom surface 20b of the supporting frame 20 and the vertical portion 45b of hook element 45 abuts against the opposite walls of the aforementioned other aperture 21b, 21a (aperture 21a in figure 1). A condition is thus reached in which the supporting member 40 cannot move with respect to the supporting frame 20 neither in both ways of a direction parallel to the inserting direction I (i.e. a direction orthogonal to the supporting frame 20) nor in both ways of a direction parallel to the direction of extension of the aperture 21a, 21b in which the hook element 45 was initially inserted (aperture 21b in figure 1), that is along a direction parallel to the axis X in figure 1 (i.e. a direction parallel to the supporting frame 20). In this condition both extraction of the hook element 45 from the opening 21 and translation of the supporting member 40 along a direction parallel to axis X in figure 1 are prevented.

Advantageously, the cross-shape of the openings 21 allows securing the supporting member 40 to the supporting frame 20 in four different orientations.

Therefore, it is similarly possible to insert the hook element 45 into aperture 21a and translate it along aperture 21b to achieve a condition in which the supporting member 40 cannot move with respect to the supporting frame 20 neither in both ways of the inserting direction I nor in both ways of a direction parallel to the direction of extension of aperture 21a (that is a direction parallel to the axis Y in figure 1). In this condition both extraction of the hook element 45 from the opening 21 and translation of the supporting member 40 along a direction parallel to axis Y in figure 1 are prevented.

In both the cases discussed above, when the supporting member 40 is at the locking position it loses two degrees of freedom in translation with respect to the supporting frame 20 while maintaining just one degree of freedom in translation with respect to the supporting frame 20. Indeed, the supporting member 40 can still translate within aperture 21a in the first case (that is along axis Y in figure 1) and within aperture 21b in the second case (that is along axis X in figure 1).

In order to eliminate this last degree of freedom, the supporting member 40 comprises a locking element 50 slidably associated with one of the side walls 42a, 42b (in particular, wall 42a in figure 1).

Preferably, as shown in the attached figures, the locking member 50 comprises a body portion 51 having, at one end thereof, a projecting portion 52.

The body portion 51 is associated with opposite sliding guides 53 formed on the side walls 42a of the supporting member 40.

The projecting portion 52 has a width, along axis X in figure 1, substantially equal to the width W of the apertures 21a, 21b. The maximum distance, along axis Y in figure 1, between projecting portion 52 and hook element 45 is substantially equal to the length 1 of apertures 21a, 21b, so that if both projecting portion 52 and hook element 45 are inserted into an aperture 21a, 21b any movement of the supporting member 40 within this aperture is prevented.

Indeed, the locking element 50 is movable by a user between a first operative position in which the hook element 45 can be inserted into, and extracted from, the opening 21, and a second operative position in which the locking element 50 is inserted into the same opening 21 in which the hook element 45 is inserted, the supporting member 40 being at the locking position. Referring to figure 1, a condition is thus reached in which the vertical portion 45b of the hook element 45 and the projecting portion 52 of the locking element 50 abuts against opposite walls of the aperture 21a, thus preventing any movement of the supporting member 50 within aperture 21a, that is along axis Y in figure 1. In this condition the last degree of freedom of the supporting member 40 with respect to the supporting frame 20 is eliminated, thus achieving a steady positioning of the supporting member 40 onto the supporting frame 20.

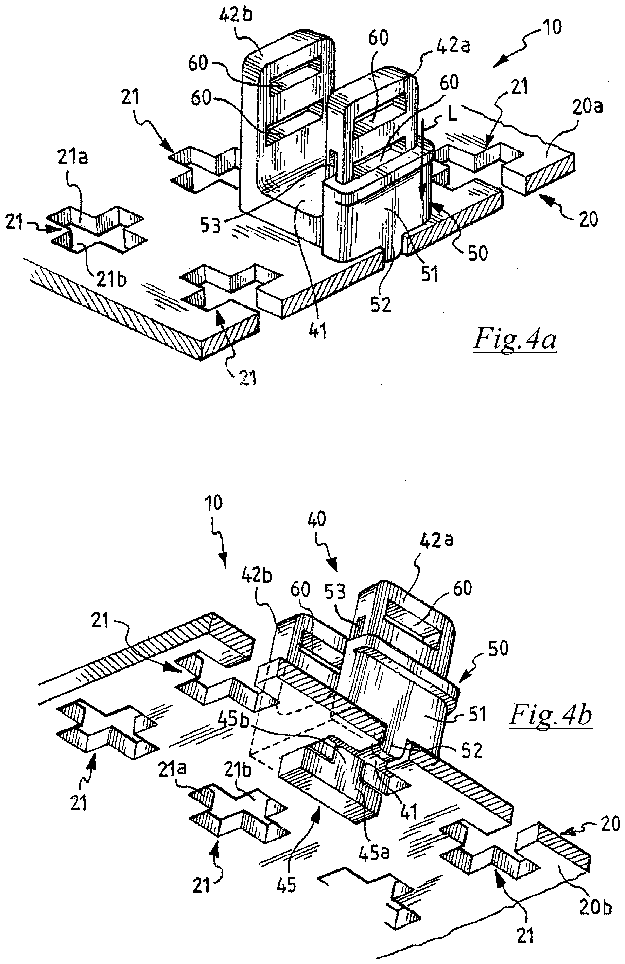

The aforementioned first and second positions of the locking element 50 are clearly shown in figures 2a, 2b, 3a, 3b, 4a, 4b. Specifically, these figures show that when locking element 50 is at the first operative position it remains out of the shaped opening 21 either when the supporting member 40 is at the inserting position (figures 2a, 2b) and when the supporting member 40 is at the locking position (figures 3a, 3b). Differently, when the locking element 50 is moved to the second operative position (arrow L in figure 4a) the locking element 50 is inserted into the aperture 21a, the supporting member 40 being still at the locking position, thus fixedly associating the supporting member 40 to the supporting frame 20.

Two parallel slots 60 are formed at different heights on each side walls 42a, 42b of the supporting member 40. Such slots are adapted to be engaged in operation by a tie element for securing components 100, 100a, 100b, 150, 150a, 150b to the supporting frame 20.

In the exemplary embodiments of figures 5 and 6, the aforementioned tie element is a double sided Velcro^{®} strap 65 which, in use, passes above components 100, 100a, 100b, 150, 150a, 150b and through at least one of the slots 60 of at least one of the side walls 42a, 42b, thus securing components 100, 100a and 100b, 150, 150a, 150b onto the supporting frame 20.

Thanks to the different heights of the two slots 60 provided on each side wall 42a, 42b, securing of devices 100, 100a and 100b of different height is allowed.

With reference to the specific embodiment of figures 1, 2a, 2b, 3a, 3b, 4a, 4b, a method for managing components of a telecommunication system (for example devices 100, 100a, 100b and/or cables 150, 150a, 150b, shown in figures 5 and 6) is described below.

This method comprises at first securing at least two supporting members 40 to the supporting frame 20. Subsequently, devices 100, 100a, 100b are arranged onto the supporting frame 20 in a position adjacent to the supporting members 40 and secured to the supporting frame 20 by properly associating tie elements 65 with the slots 60 of the supporting members 40.

While two supporting members 40 are used in the embodiment described and shown in figure 6 for securing each single device 100a, 100b, another embodiment is which four supporting members 40 are used for securing a single device 100 is provided, as shown in figure 5.

Opening 21 wherein supporting members 40 should be secured are selected depending on the shape of the devices 100, 100a, 100b to be secured.

Then, horizontal portion 45a of the hook element 45 of each supporting member 40 is aligned with one of the apertures 21a, 21b of a respective opening 21. In the specific example shown in figure 1, horizontal portion 45a is aligned with aperture 21b.

Locking element 50 is at this time at the first operative position thereof.

Subsequently, supporting member 40 is moved along the insertion direction I toward supporting frame 40 in order to insert hook element 45 into the opening 21 and up to reach the inserting position shown in figures 2a and 2b, in which the bottom wall 41 of the supporting member 40 abuts against the top surface 20a of the supporting frame 20.

Supporting member 40 is then translated within aperture 21a to reach the locking position shown in figures 3a, 3b, in which the bottom wall 41 abuts against the bottom surface 20a of the supporting frame 20 and the vertical portion 45b of hook element 45 abuts against opposite side walls of aperture 21a along a direction parallel to axis X in figure 1. In this position, supporting member 40 cannot move neither along a direction parallel to axis Z in figure 1 nor along a direction parallel to axis X in figure 1, but it can still move within aperture 21a along a direction parallel to axis Y. Therefore, only two of the three degrees of freedom in translation of the supporting member 40 with respect to the supporting frame 20 have been eliminated.

Thereafter, the locking element 50 is moved by a user from the first operative position of figures 1, 2a, 2b, 3a, 3b to the second operative position of figures 4a, 4b, so as to be inserted into aperture 21a. A final condition is thus reached in which the vertical portion 45b of the hook element 45 and the projecting portion 52 of the locking element 50 abut against opposite side walls of aperture 21a along axis Y in figure 1. In this final condition the last degree of freedom of the supporting member 40 with respect to the supporting frame 20 is eliminated. The supporting member 40 is thus fixedly secured to the supporting frame 20.

Upon securing the two supporting members 40 (with reference to the embodiment of figure 6) or four supporting members 40 (with reference to the embodiment of figure 5) to the respective openings 21 of the supporting frame 20, device 100, 100a, 100b is disposed within the area delimited by the four supporting members 40. The tie elements 65 are then passed above device 100, 100a, 100b and associated with the slots 60 of two opposite supporting members 40.

Depending on the height of component 100, 100a, 100b, tie elements 65 are passed through the lower or upper slots 60 of the side wall 42a, 42b of the supporting members 40 so as to always ensure a strong tightening of device 100, 100a, 100b against the supporting frame 20.

Preferably, as shown in figures 5 and 6, at the side of the device 100, 100a, 100b wherein the cable 150, 150a, 150b, respectively, is provided, the tie fasteners 65 pass through the slots 60 of both the side walls 42a, 42b of the supporting member 40. Differently, on the opposite side, that is at the side where no cable is provided, the tie fasteners 65 pass just on the slot 60 of the side wall 42a, 42b closer to the component 100, 100a, 100b. This advantageously allows using the supporting member 40 provided at the side where no cable is provided to secure to the supporting frame 20 two different devices 100a, 100b arranged on opposite sides with respect to said supporting member 40. This is clearly shown in figure 6, wherein supporting member 40 arranged between components 100a and 100b is used to secure both components 100a, 100b to the supporting frame 20.

In addition thereof, referring once again to figures 5 and 6 and specifically to the supporting members 40 arranged at the side of the component 100, 100a, 100b wherein cable 150, 150a, 150b, respectively, is provided, these supporting members 40 may advantageously be used to provide also for a proper cable management. This is achieved by having the tie element 65 passed through the slots 60 on both the side walls of the supporting member 40, and the cable 150, 150a, 150b passed between the side walls 42a 42b and between the tie element 65 and the bottom wall 41. A condition is thus reached in which cable 150, 150a, 150b is restrained in a specific location with respect to the supporting frame, thus providing an organized layout of both devices 100, 100a, 100b and cables 150, 150a, 150b. This allows providing a tidy and safe installation, in which the likelihood of cables tangling and damaging is reduced as well as the risk of excessive bending of the cables is avoided, so as to avoid undesired attenuation and loss of signal strengths.

From the above it is clear that mounting and dismounting of the supporting members 40 to and from the supporting frame 20 does not require the use of any tools and/or other conventional fasteners. Thanks to the possibility to lock the supporting members into any of the openings 21 of the supporting frame 20 and to the use of the tie element 65 as well as to the provision of the slots 60 on the side walls 42a, 42b of the supporting members 40, components 100, 100a, 100b of different size and shape can be secured to the supporting frame 20.

## Claims

1. Assembly (10) for managing components (100, 100a, 100b, 150, 150a, 150b) of a telecommunication system, comprising:
- a supporting frame (20) having at least one shaped opening (21);
- at least one supporting member (40) for said component (100, 100a, 100b, 150, 150a, 150b), said supporting member (40) having an integral portion (45) adapted to be inserted into said shaped opening (21) along an inserting direction (I) ;
- a locking element (50) associated with said supporting member (40) and movable on said supporting member, along a direction parallel to the inserting direction (I), between a first operative position in which said integral portion (45) of the supporting member (40) can be inserted into said shaped opening (21) and extracted therefrom, and a second operative position in which extraction of said integral portion (45) of the supporting member (40) from said shaped opening (21) is prevented, thereby fixedly associating said supporting member (40) with said supporting frame (20).

2. Assembly (10) according to claim 1, wherein said supporting member (40) is movable within said shaped opening (21) between an inserting position defined along an inserting direction (I) and a locking position, and wherein said integral portion (45) comprises a hook element (45) which, when the supporting member (40) is at the locking position, is inserted into the shaped opening (21) and prevents any movement of the supporting member (40) in the opposite way to said inserting direction (I).

3. Assembly (10) according to claim 2, wherein when said supporting member (40) is at said locking position, said hook element (45) further prevents any movement of the supporting member (40) along a first direction perpendicular to said inserting direction (I).

4. Assembly (10) according to claim 3, wherein when said locking element (50) is at said second operative position the supporting member (40) is at said locking position and the locking element (50) is inserted into said shaped opening (21), thus preventing any movement of the supporting member (40) along a second direction perpendicular to said inserting direction (I) and to said first direction.

5. Assembly (10) according to claim 2, wherein said supporting member (40) is substantially U-shaped and comprises a bottom wall (41) and two opposite side walls (42a, 42b), said hook element (45) being associated with said bottom wall (41) on the opposite side with respect to said side walls (42a, 42b) and said locking element (50) being associated with one of said side walls (42a, 42b) and movable along said direction parallel to the inserting direction (I).

6. Assembly (10) according to claim 1, comprising a tie element (65) adapted to be associated with said supporting member (40) to secure said component (100, 100a, 100b, 150, 150a, 150b) onto said supporting frame (20).

7. Assembly (10) according to claim 6, wherein said supporting member (40) comprises at least one slot (60) for associating said tie element (65) with the supporting member (40).

8. Assembly (10) according to claims 5 and 7, wherein said at least one slot (60) is formed on one of said side walls (42a, 42b).

9. Assembly (10) according to claim 1, wherein said shaped opening (21) is cross-shaped or T-shaped or star-shaped.

10. Method for managing components (100, 100a, 100b, 150, 150a, 150b) of a telecommunication system, comprising:
- providing a supporting frame (20) having at least one shaped opening (21);
- providing at least one supporting member (40) for said component (100, 100a, 100b, 150, 150a, 150b), said supporting member (40) having an integral portion (45) adapted to be inserted into said shaped opening (21);
- inserting said integral portion (45) of the supporting member (40) into said shaped opening (21) along an inserting direction (I);
- moving a locking element (50) associated with said supporting member (40) along a direction parallel to said inserting direction (I) from a first operative position in which said integral portion (45) of the supporting member (40) can be inserted into said shaped opening (21) and extracted therefrom, to a second operative position in which said locking element (50) prevents the extraction of said integral portion (45) of the supporting member (40) from said shaped opening (21) and fixedly associates said supporting member (40) with said supporting frame (20).

11. Method according to claim 10, comprising, before moving said locking element (50) from said first operative position to said second operative position, moving said supporting member (40) within said shaped opening (21) from the inserting position to a locking position in which any movement of the supporting member (40) in the opposite way to the inserting direction (I) is prevented.

12. Method according to claim 11, wherein when said supporting member (40) is at said locking position, any movement of the supporting member (40) along a first direction perpendicular to the inserting direction (I) is further prevented.

13. Method according to claim 11, wherein when said supporting member (40) is at said locking position and said locking element (50) is at said second operative position, any movement of the supporting member (40) along a second direction perpendicular to the inserting direction (I) and the first direction is further prevented.

14. Method according to claim 10, comprising:
- arranging said component (100, 100a, 100b, 150, 150a, 150b) onto said supporting frame (20) in a position adjacent to said supporting member (40);
- associating a tie element (65) with said supporting member (40) to secure said component (100, 100a, 100b, 150, 150a, 150b) onto said supporting frame (20).

15. Method according to claim 10, wherein said supporting member (40), before the insertion into said shaped opening (21), has three degrees of freedom in translation with respect to said supporting frame (20) and:
- when said integral portion (45) of said supporting member (40) is inserted into said shaped opening (21), said supporting member (40) looses two of said degrees of freedom with respect to said supporting frame(20), and
- when said locking element (50) is inserted into said shaped opening (21), said supporting member (40) looses the last of said degrees of freedom with respect to said supporting frame (20).

## Patentansprüche

1. Anordnung (10) zum Verwalten von Komponenten (100, 100a, 100b, 150, 150a, 150b) eines Kommunikationssystems, die umfasst:
- einen Trägerrahmen (20) mit wenigstens einer geformten Öffnung (21);
- wenigstens ein Trägerelement (40) für die Komponente (100, 100a, 100b, 150, 150a, 150b), wobei das Trägerelement (40) einen integralen Teil (45) hat, der angepasst ist, um in die geformte Öffnung (21) längs einer Einsetzrichtung (I) eingesetzt zu werden;
- ein Sperrelement (50), das mit dem Trägerelement (40) verbunden und an dem Trägerelement längs einer Richtung parallel zur Einsetzrichtung (I) zwischen einer ersten Arbeitsposition, in der der integrale Teil (45) des Trägerelements (40) in die geformte Öffnung (21) eingesetzt und davon herausgezogen werden kann, und einer zweiten Arbeitsposition bewegbar ist, in der das Herausziehen des integralen Teils (45) des Trägerelements (40) aus der geformten Öffnung (21) verhindert wird, wobei dadurch das Trägerelement (40) mit dem Trägerrahmen (20) fest verbunden wird.

2. Anordnung (10) nach Anspruch 1, wobei das Trägerelement (40) in der geformten Öffnung (21) zwischen einer Einsetzposition, die längs einer Einsetzrichtung (I) definiert ist, und einer Sperrposition bewegbar ist und wobei der integrale Teil (45) ein Hakenelement (45) umfasst, das, wenn sich das Trägerelement (40) in der Sperrposition befindet, in die geformte Öffnung (21) eingesetzt wird und jede Bewegung des Trägerelements (40) in die entgegengesetzte Richtung zu der Einsetzrichtung (I) verhindert.

3. Anordnung (10) nach Anspruch 2, wobei, wenn sich das Trägerelement (40) in der Sperrposition befindet, das Hakenelement (45) des Weiteren jede Bewegung des Trägerelements (40) längs einer ersten Richtung rechtwinklig zu der Einsetzrichtung (I) verhindert.

4. Anordnung (10) nach Anspruch 3, wobei, wenn sich das Sperrelement (50) in der zweiten Arbeitsposition befindet, sich das Trägerelement (40) in der Sperrposition befindet und das Sperrelement (50) in die geformte Öffnung (21) eingesetzt wird, wobei damit jede Bewegung des Trägerelements (40) längs einer zweiten Richtung rechtwinklig zu der Einsetzrichtung (I) und der ersten Richtung verhindert wird.

5. Anordnung (10) nach Anspruch 2, wobei das Trägerelement (40) im Wesentlichen U-förmig ist und eine untere Wand (41) und zwei gegenüberliegende Seitenwände (42a, 42b) umfasst, wobei das Hakenelement (45) mit der unteren Wand (41) an der gegenüberliegenden Seite mit Bezug auf die Seitenwände (42a, 42b) verbunden ist und das Sperrelement (50) mit einer der Seitenwände (42a, 42b) verbunden ist und in der Richtung parallel zu der Einsetzrichtung (I) bewegbar ist.

6. Anordnung (10) nach Anspruch 1, das ein Bindeelement (65) umfasst, das so angepasst ist, dass es mit dem Trägerelement (40) verbunden ist, um die Komponente (100, 100a, 100b, 150, 150a, 150b) auf dem Trägerrahmen (20) zu sichern.

7. Anordnung (10) nach Anspruch 6, wobei das Trägerelement (40) wenigstens einen Schlitz (60) zum Verbinden des Bindeelements (65) mit dem Trägerelement (40) umfasst.

8. Anordnung (10) nach Anspruch 5 und 7, wobei der wenigstens eine Schlitz (60) an einer der Seitenwände (42a, 42b) ausgebildet ist.

9. Anordnung (10) nach Anspruch 1, wobei die geformte Öffnung (21) kreuzförmig oder T-förmig oder sternförmig ist.

10. Verfahren zum Verwalten von Komponenten (100, 100a, 100b, 150, 150a, 150b) eines Telekommunikationssystems, das umfasst:
- Bereitstellen eines Trägerrahmens (20) mit wenigstens einer geformten Öffnung (21);
- Bereitstellen von wenigstens einem Trägerelement (40) für die Komponente (100, 100a, 100b, 150, 150a, 150b), wobei das Trägerelement (40) einen integralen Teil (45) hat, der angepasst ist, um in die geformte Öffnung (21) eingesetzt zu werden;
- Einsetzen des integralen Teils (45) des Trägerelements (40) in die geformte Öffnung (21) längs einer Einsetzrichtung (I);
- Bewegen eines Sperrelements (50), das mit dem Trägerelement (40) verbunden ist, längs einer Richtung parallel zu der Einsetzrichtung (I) von einer ersten Arbeitsposition, in der der integrale Teil (45) des Trägerelements (40) in die geformte Öffnung (21) eingesetzt und davon herausgezogen werden kann, in eine zweite Arbeitsposition, in der das Sperrelement (50) das Herausziehen des integralen Teils (45) des Trägerelements (40) aus der geformten Öffnung (21) verhindert und das Trägerelement (40) mit dem Trägerrahmen (20) fest verbindet.

11. Verfahren nach Anspruch 10, das vor dem Bewegen des Sperrelements (50) von der ersten Arbeitsposition in die zweite Arbeitsposition das Bewegen des Trägerelements (40) in der geformten Öffnung (21) von der Einsetzposition in eine Sperrposition umfasst, in der jede Bewegung des Trägerelements (40) in die entgegengesetzte Richtung zur Einsetzrichtung (I) verhindert wird.

12. Verfahren nach Anspruch 11, wobei, wenn sich das Trägerelement (40) in der Sperrposition befindet, jede Bewegung des Trägerelements (40) längs einer ersten Richtung rechtwinklig zur Einsetzrichtung (I) weiter verhindert wird.

13. Verfahren nach Anspruch 11, wobei, wenn sich das Trägerelement (40) in der Sperrposition befindet und sich das Sperrelement (50) in der zweiten Arbeitsposition befindet, jede Bewegung des Trägerelements (40) längs einer zweiten Richtung rechtwinklig zu der Einsetzrichtung (I) und der ersten Richtung weiter verhindert wird.

14. Verfahren nach Anspruch 10, das umfasst:
- Anordnen der Komponente (100, 100a, 100b, 150, 150a, 150b) auf dem Trägerrahmen (20) in einer Position angrenzend an das Trägerelement (40);
- Verbinden eines Bindeelements (65) mit dem Trägerelement (40), um die Komponente (100, 100a, 100b, 150, 150a, 150b) auf dem Trägerrahmen (20) zu sichern.

15. Verfahren nach Anspruch 10, wobei das Trägerelement (40) vor dem Einsetzen in die geformte Öffnung (21) drei Freiheitsgrade in der Translation mit Bezug auf dem Trägerrahmen (20) hat und:
- wenn der integrale Teil (45) des Halteelements (40) in die geformte Öffnung (21) eingesetzt wird, das Trägerelement (40) zwei der Freiheitsgrade mit Bezug auf den Trägerrahmen (20) verliert und,
- wenn das Sperrelement (50) in die geformte Öffnung (21) eingesetzt wird, das Trägerelement (40) den letzten der Freiheitsgrade mit Bezug auf den Trägerrahmen (20) verliert.

## Revendications

1. Ensemble (10) pour gérer des composants (100, 100a, 100b, 150, 150a, 150b) d'un système de télécommunication, comprenant :
- un cadre de support (20) présentant au moins une ouverture formée (21) ;
- au moins un élément de support (40) pour ledit composant (100, 100a, 100b, 150, 150a, 150b), ledit élément de support (40) présentant une partie intégrale (45) adaptée pour être insérée dans ladite ouverture formée (21) le long d'une direction d'insertion (I) ;
- un élément de verrouillage (50) associé audit élément de support (40) et mobile sur ledit élément de support le long d'une direction parallèle à la direction d'insertion (I), entre une première position opérationnelle, dans laquelle ladite partie intégrale (45) de l'élément de support (40) peut être insérée dans ladite ouverture formée (21) et extraite de celle-ci, et une seconde position opérationnelle, dans laquelle l'extraction de ladite partie intégrale (45) de l'élément de support (40) de ladite ouverture formée (21) est empêchée, associant ainsi fixement ledit élément de support (40) audit cadre de support (20).

2. Ensemble (10) selon la revendication 1, dans lequel ledit élément de support (40) est mobile dans ladite ouverture formée (21) entre une position d'insertion définie le long d'une direction d'insertion (I) et une position de verrouillage, et dans lequel ladite partie intégrale (45) comprend un élément de crochet (45) qui, lorsque l'élément de support (40) est sur la position de verrouillage, est inséré dans l'ouverture formée (21) et empêche tout mouvement de l'élément de support (40) dans le sens inverse à ladite direction d'insertion (I).

3. Ensemble (10) selon la revendication 2, dans lequel lorsque ledit élément de support (40) est sur ladite position de verrouillage, ledit élément de crochet (45) empêche en outre tout mouvement de l'élément de support (40) le long d'une première direction perpendiculaire à ladite direction d'insertion (I).

4. Ensemble (10) selon la revendication 3, dans lequel lorsque ledit élément de verrouillage (50) est sur ladite seconde position opérationnelle, l'élément de support (40) est sur ladite position de verrouillage et l'élément de verrouillage (50) est inséré dans ladite ouverture formée (21), empêchant ainsi tout mouvement de l'élément de support (40) le long d'une seconde direction perpendiculaire à ladite direction d'insertion (I) et à ladite première direction.

5. Ensemble (10) selon la revendication 2, dans lequel ledit élément de support (40) est sensiblement en forme de U et comprend une paroi inférieure (41) et deux parois latérales en regard (42a, 42b), ledit élément de crochet (45) étant associé à ladite paroi inférieure (41) sur le côté opposé par rapport auxdites parois latérales (42a, 42b) et ledit élément de verrouillage (50) étant associé à une desdites parois latérales (42a, 42b) et mobile le long de ladite direction parallèle à la direction d'insertion (I).

6. Ensemble (10) selon la revendication 1, comprenant un élément d'attache (65) adapté pour être associé audit élément de support (40) pour fixer ledit composant (100, 100a, 100b, 150, 150a, 150b) sur ledit cadre de support (20).

7. Ensemble (10) selon la revendication 6, dans lequel ledit élément de support (40) comprend au moins une fente (60) pour associer ledit élément d'attache (65) à l'élément de support (40).

8. Ensemble (10) selon les revendications 5 et 7, dans lequel ladite au moins une fente (60) est formée sur une desdites parois latérales (42a, 42b).

9. Ensemble (10) selon la revendication 1, dans lequel ladite ouverture formée (21) est en forme de croix, ou en forme de T ou en forme d'étoile.

10. Procédé pour gérer des composants (100, 100a, 100b, 150, 150a, 150b) d'un système de télécommunication, comprenant :
- la fourniture d'un cadre de support (20) présentant au moins une ouverture formée (21) ;
- la fourniture d'au moins un élément de support (40) pour ledit composant (100, 100a, 100b, 150, 150a, 150b), ledit élément de support (40) présentant une partie intégrale (45) adaptée pour être insérée dans ladite ouverture formée (21) ;
- l'insertion de ladite partie intégrale (45) de l'élément de support (40) dans ladite ouverture formée (21) le long d'une direction d'insertion (I) ;
- le déplacement d'un élément de verrouillage (50) associé audit élément de support (40) le long d'une direction parallèle à ladite direction d'insertion (I) d'une première position opérationnelle, dans laquelle ladite partie intégrale (45) de l'élément de support (40) peut être insérée dans ladite ouverture formée (21) et extraite de celle-ci, à une seconde position opérationnelle, dans laquelle ledit élément de verrouillage (50) empêche l'extraction de ladite partie intégrale (45) de l'élément de support (40) de ladite ouverture formée (21) et associe fixement ledit élément de support (40) audit cadre de support (20).

11. Procédé selon la revendication 10, comprenant avant le déplacement dudit élément de verrouillage (50) de ladite première position opérationnelle à ladite seconde position opérationnelle, le déplacement dudit élément de support (40) dans ladite ouverture formée (21) de la position d'insertion à une position de verrouillage, dans laquelle tout mouvement de l'élément de support (40) dans le sens inverse à la direction d'insertion (I) est empêché.

12. Procédé selon la revendication 11, dans lequel lorsque ledit élément de support (40) est sur ladite position de verrouillage, tout mouvement de l'élément de support (40) le long d'une première direction perpendiculaire à la direction d'insertion (I) est en outre empêché.

13. Procédé selon la revendication 11, dans lequel lorsque ledit élément de support (40) est sur ladite position de verrouillage et ledit élément de verrouillage (50) est sur ladite seconde position opérationnelle, tout mouvement de l'élément de support (40) le long d'une seconde direction perpendiculaire à la direction d'insertion (I) et la première direction est en outre empêché.

14. Procédé selon la revendication 10, comprenant :
- l'agencement dudit composant (100, 100a, 100b, 150, 150a, 150b) sur ledit cadre de support (20) dans une position adjacente audit élément de support (40) ;
- l'association d'un élément d'attache (65) audit élément de support (40) pour fixer ledit composant (100, 100a, 100a, 100b, 150, 150a, 150b) sur ledit cadre de support (20).

15. Procédé selon la revendication 10, dans lequel ledit élément de support (40) avant l'insertion dans ladite ouverture formée (21) a trois degrés de liberté en translation par rapport audit cadre de support (20) et :
- lorsque ladite partie intégrale (45) dudit élément de support (40) est insérée dans ladite ouverture formée (21), ledit élément de support (40) perd deux desdits degrés de liberté par rapport audit cadre de support (20) et
- lorsque ledit élément de verrouillage (50) est inséré dans ladite ouverture formée (21), ledit élément de support (40) perd le dernier desdits degrés de liberté par rapport audit cadre de support (20).
